(19) Europäisches Patentamt
European Patent Office
Office européen des brevets

(11) **EP 1 407 546 B1**

(12) **EUROPÄISCHE PATENTSCHRIFT**

(45) Veröffentlichungstag und Bekanntmachung des Hinweises auf die Patenterteilung:
**07.07.2010 Patentblatt 2010/27**

(21) Anmeldenummer: **02737839.7**

(22) Anmeldetag: **16.05.2002**

(51) Int Cl.:
*H03H 9/58* *(2006.01)*

(86) Internationale Anmeldenummer:
**PCT/DE2002/001761**

(87) Internationale Veröffentlichungsnummer:
**WO 2003/009470 (30.01.2003 Gazette 2003/05)**

(54) **REAKTANZFILTER MIT VERBESSERTER FLANKENSTEILHEIT**

REACTANCE FILTER HAVING AN IMPROVED EDGE STEEPNESS

FILTRE RÉACTANCE À PENTE DE FLANC AMÉLIORÉE

(84) Benannte Vertragsstaaten:
**DE FR GB**

(30) Priorität: **18.07.2001 DE 10134987**

(43) Veröffentlichungstag der Anmeldung:
**14.04.2004 Patentblatt 2004/16**

(73) Patentinhaber: **EPCOS AG**
**81669 München (DE)**

(72) Erfinder: **UNTERBERGER, Michael**
**82008 Unterhaching (DE)**

(74) Vertreter: **Epping - Hermann - Fischer**
**Patentanwaltsgesellschaft mbH**
**Ridlerstrasse 55**
**80339 München (DE)**

(56) Entgegenhaltungen:
**DE-A- 19 638 451**

- **PATENT ABSTRACTS OF JAPAN vol. 013, no. 068 (E-716), 16. Februar 1989 (1989-02-16) & JP 63 253711 A (KYOCERA CORP), 20. Oktober 1988 (1988-10-20)**

**Beschreibung**

Die Erfindung betrifft Volumenwellenfilter (bulk acustic wave filter oder auch BAW-Filter genannt), die nach dem Reaktanzfilterprinzip aufgebaut sind.

Aus einem Artikel von K. M. Lakin et al. in "Microwave Symposium Digest", IEEE MTT-S international 1995, Seiten 883 bis 886 ist es bekannt, Reaktanzfilter aus BAW-Resonatoren aufzubauen. Dabei werden diese als Impedanzelemente verwendet und beispielsweise zu Ladder Type oder zu Lattice Filtern verschaltet. Diese Art von Verschaltungen zur Herstellung von Filtern wird auch als Abzweigtechnik bezeichnet.

Weitere Reaktanzfilter sind beispielsweise auch aus der DE 196 38 451 A und der JP 63 253711 A bekannt.

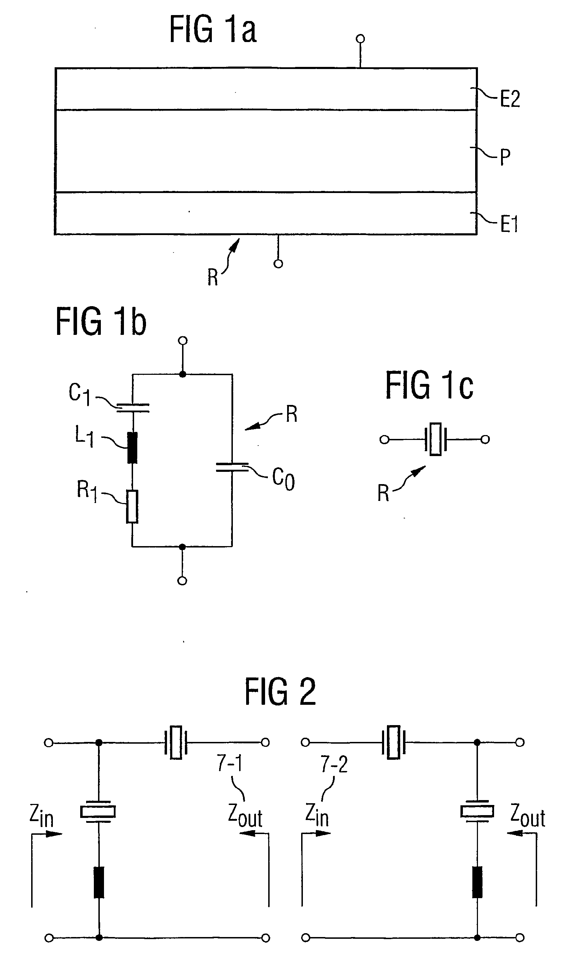

Ein BAW-Resonator R besteht gemäß Figur 1a in seiner einfachsten Ausführungsform aus einem dünnen Film P eines piezoelektrischen Materials, der auf der Ober- und Unterseite jeweils mit einer Elektrode E1, E2 versehen ist. Idealerweise ist diese Struktur auf beiden Elektrodenseiten von Luft umgeben. Beim Anlegen einer elektrischen Spannung an die Elektroden wirkt ein elektrisches Feld auf die piezoelektrische Schicht ein, in Folge dessen das piezoelektrische Material einen Teil der elektrischen Energie in mechanische Energie in Form von akustischen Wellen umwandelt. Diese breiten sich parallel zur Feldrichtung als sogenannte Volumenwellen aus und werden an den Grenzflächen Elektrode/Luft reflektiert. Bei einer bestimmten, von der Dicke der piezoelektrischen Schicht bzw. von der Dicke des Volumenschwingers abhängigen Frequenz $f_r$ zeigt der Resonator eine Resonanz und verhält sich damit wie ein elektrischer Resonator.

Im Ersatzschaltbild gemäß Figur 1b besteht der BAW-Resonator R aus einer Serienresonanzschaltung aus dynamischer Induktivität L1, dynamischer Kapazität C1 und einem dynamischen Widerstand R1, sowie einer parallel dazu geschalteten statischen Kapazität C0 des BAW-Resonators. Die Serienresonanzschaltung gibt das Verhalten des Resonators im Resonanzfall wieder, also im Bereich der Resonanzfrequenz $f_r$. Die statische Kapazität C0 gibt das Verhalten im Bereich $f \ll f_r$ und $f_r \gg f$ wieder. Die dynamische Kapazität C1 ist dabei proportional zur statischen Kapazität C0 des BAW-Resonators.

$$C1 \sim C0. \qquad\qquad (1.1)$$

Für die Resonanzfrequenz $f_r$ und die Antiresonanzfrequenz $f_a$ eines BAW-Resonators gelten:

$$f_r = \frac{1}{2\pi\sqrt{(L1 \cdot C1)}} \qquad\qquad (1.2)$$

$$f_a = f_r \sqrt{1 + C1/C0} \qquad\qquad (1.3)$$

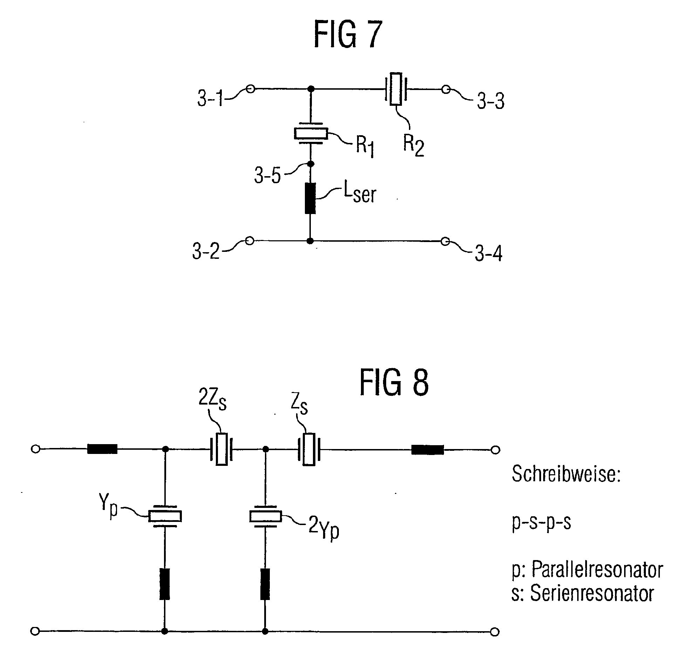

Ein Reaktanzfilter besteht gemäß Figur 7 aus mindestens einem Grundglied, welches einen seriell geschalteten Resonator R2 mit einer Resonanzfrequenz $f_{rs}$ und zugehörige Antiresonanzfrequenz $f_{as}$ und einen zweiten, parallel zu einem zweiten Anschluß, insbesondere parallel zur Masse geschalteten Resonator R1 mit einer Resonanzfrequenz $f_{rp}$ und dazugehörige Antiresonanzfrequenz $f_{ap}$. Zur Erzeugung eines Filters mit Bandpaßverhalten und einer Mittenfrequenz $f_0$ gilt für die beiden Resonatoren im seriellen bzw. parallelen Zweig folgende Beziehung:

$$f_{ap} \approx f_{rs} \approx f_0 \qquad\qquad (1.4)$$

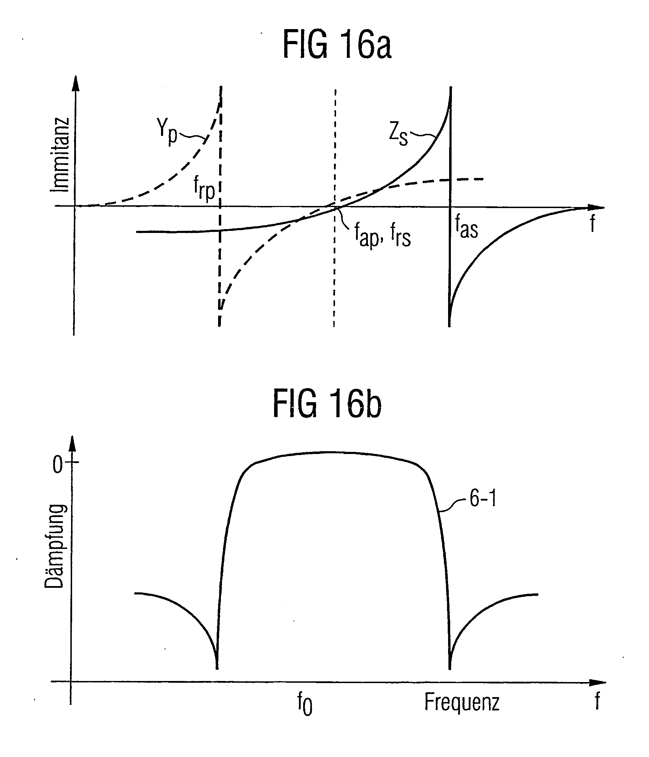

Figur 16a zeigt den Verlauf der Impedanz Zs des seriellen Resonators und der Admittanz Yp des parallelen Resonators über die Frequenz f. Figur 16b zeigt das Durchlaßverhalten eines aus einem Grundglied bestehenden Filters, dessen Resonanzfrequenzen wie Figur 16a ausgewählt sind. Figur 7 zeigt ein Grundglied, das prinzipiell als Zweitor mit den Anschlüssen 3 - 1 bzw. 3 - 2 (Tor 1) und den Anschlüssen 3 - 3 bzw. 3- 4 von Tor 2 zu betrachten ist. Gleichzeitig ist der Anschluß 3 - 1 der Eingang und der Anschluß 3 - 3 der Ausgang des Serienresonators. Der Eingang des Parallelresonators ist mit dem Anschluß 3 - 1 verbunden. Die Anschlüsse 3 - 2 und 3 - 4 stellen bei einem unsymmetrischen Betrieb die Bezugsmasse dar. Der Ausgang des Parallelresonators 3 - 5, der der Bezugsmasse zugewandt ist, wird im Folgenden als Ausgangs- bzw. Masseseite des Parallelresonators bezeichnet. Die Induktivität $L_{ser}$, die zwischen der Ausgangsseite des Parallelresonators und der Bezugsmasse liegt, spiegelt den Anschluß an die Gehäusemasse im realen Aufbau wieder.

Das Selektionsniveau eines aus BAW-Resonatoren aufgebauten Reaktanzfilters wird zum einen durch das Verhältnis $C0_p / C0_s$ aus statischer Kapazität $C0_p$ im Parallelzweig und statischer Kapazität $C0_s$ im Serienzweig bestimmt, zum anderen durch die Anzahl der kaskadierten, also der miteinander in Reihe geschalteten Grundglieder.

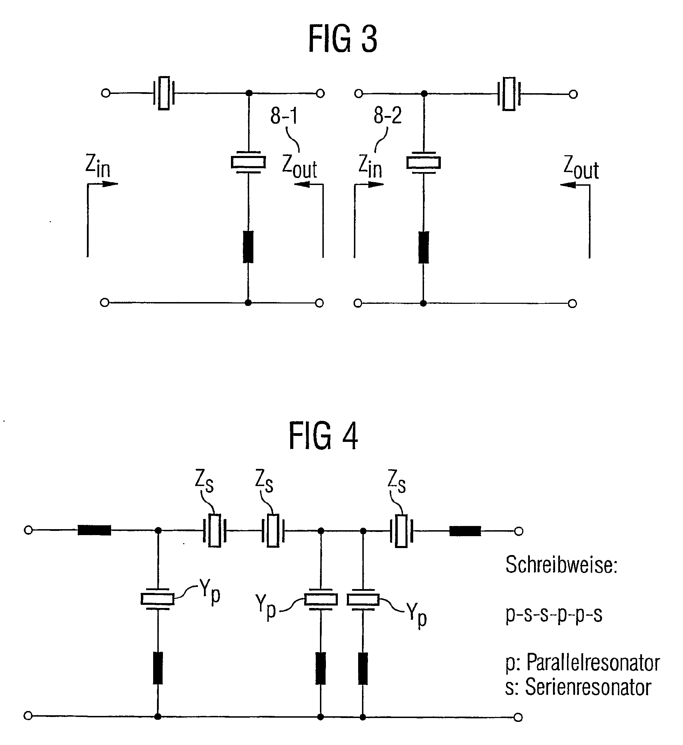

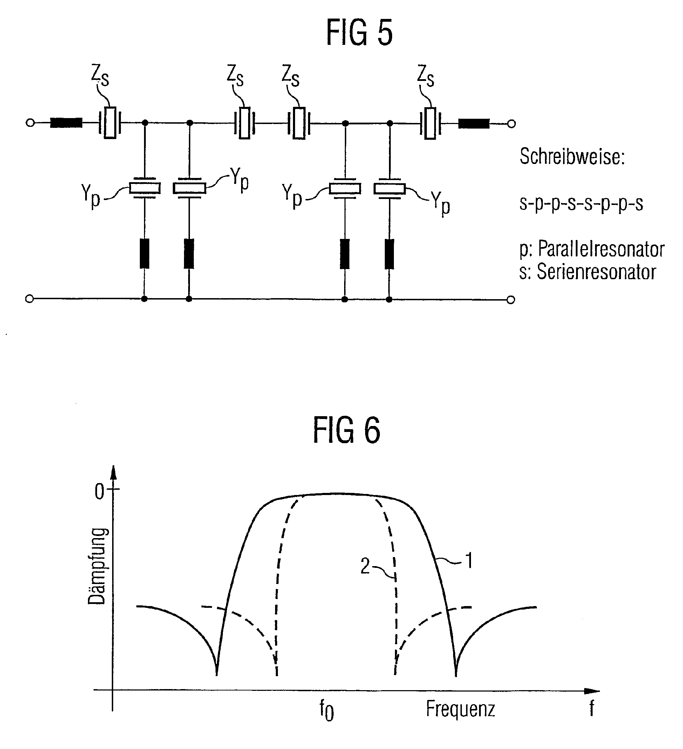

Mehrere Grundglieder können angepaßt miteinander verschaltet werden, wobei die Struktur zweiter benachbarter Grundglieder jeweils gespiegelt ist. Dann ist die Ausgangsimpedanz des ersten Grundglieds (7-1 in Figur 2 oder 8-1 in Figur 3) gleich der Eingangsimpedanz des zweiten Grundglieds (7-2 in Figur 2 bzw. 8-2 in Figur 3), so daß nur minimale Verluste durch Fehlanpassung erzeugt werden. Für die Verschaltung mehrerer Grundglieder sind vielerlei Strukturen bekannt. Einige Beispiele sind in den Figuren 4 und 5 dargestellt.

Unmittelbar in einer Verschaltung eines Reaktanzfilters hintereinander liegende Resonatoren gleichen Typs (Serienresonator oder Parallelresonator) können auch jeweils zu einem Resonator zusammengefaßt werden, wobei die kapazitive Gesamtwirkung des zusammengefaßten Resonators gleichbleibt.

Aus den Formeln (1.2) bis (1.4) ist ersichtlich, daß sowohl die maximal erreichbare Bandbreite als auch die Steilheit der Flanken eines solchen Reaktanzfilters von der Differenz aus Resonanz- und Antiresonanzfrequenz der einzelnen Resonatoren abhängt. Diese Differenz wiederum ergibt sich aus dem Verhältnis von dynamischer Kapazität C1 und statischer Kapazität C0. Da diese Kapazitäten zueinander proportional sind, ändert sich das Kapazitätsverhältnis C1/C0 durch eine Änderung einer dieser Kapazitäten nicht. Beispielsweise könnte C0 durch Änderung der Größe des Resonators variiert werden. In der Regel haben alle Resonatoren eines Reaktanzfilters die gleiche relative Bandbreite (fa - fr)/f0.

Die Kurve 1 in Figur 6 zeigt das Durchlaßverhalten eines Reaktanzfilters, das aus einheitlichen BAW-Resonatoren aufgebaut ist, die jeweils ein relativ großes Verhältnis von dynamischer zur statischer Kapazität aufweisen. Die Einzelresonatoren weisen daher eine relativ große Bandbreite auf. Kurve 2 ist die Durchlaßkurve eines entsprechenden Reaktanzfilters aus Resonatoren mit einem kleinen Verhältnis von dynamischer zu statischer Kapazität und daher relativ geringer Bandbreite der Einzelresonatoren. Im ersten Fall (Kurve 1) erhält man ein Bandpaßfilter mit hoher Bandbreite und geringer Flankensteilheit, im zweiten Fall (Kurve 2) erhält man ein Bandpaßfilter mit geringerer Bandbreite und hoher Flankensteilheit.

Versucht man nun, bei einem solchen steilflankigen Filter, die Bandbreite auf das Niveau desjenigen Filters mit dem größeren Kapazitätsverhältnis zu erhöhen, indem man die Mittenfrequenzen von Serienresonatoren erhöht und/oder die Mittenfrequenz der Parallelresonatoren verringert, erhält man in der Mitte des Paßbandes eine starke Fehlanpassung, da nunmehr $f_{ap} << f_{rs}$. Damit ist die Bedingung (1.4) nicht mehr erfüllt. Daher steigen auch die Verluste in der Mitte des Paßbandes stärker an.

Eine weitere Möglichkeit zur Verbreiterung eines steilflankigen Filters besteht in einer Verkleinerung des Verhältnisses ($C_{0p}/C_{0s}$) von statischer Kapazität $C0_p$ im Parallelzweig und statischer Kapazität C0s im Serienzweig. Dadurch kann die Bandbreite in einem gewissem Maße vergrößert werden, ohne die Selbstanpassung und die damit verbundenen geringen Verluste zu verlieren. Mit dieser Maßnahme wird aber das Selektionsniveau des BAW-Reaktanzfilters stark reduziert, so daß das Filter mögliche Selektionsanforderungen nicht mehr erfüllen kann und unerwünschte Frequenzen beispielsweise nicht mehr ausreichend abdämpfen kann.

Aufgabe der vorliegenden Erfindung ist es daher, ein aus BAW-Resonatoren aufgebautes Reaktanzfilter anzugeben, welches eine verbesserte Flankensteilheit bei ausreichender Bandbreite aufweist, ohne daß dazu eine zusätzliche Anpassung oder eine Reduktion des Selektionsniveaus aufgenommen werden muß.

Diese Aufgabe wird erfindungsgemäß durch ein Reaktanzfilter mit den Merkmalen von Anspruch 1 gelöst.

Vorteilhafte Ausgestaltungen der Erfindung sowie bevorzugte Anwendungen der Erfindung sind weiteren Ansprüchen zu entnehmen.

Die Erfindung nutzt die Tatsache, daß für die HF-Filter in vielen Mobilfunksystemen hohe Anforderungen an die Bandabgrenzung jeweils nur zum entsprechenden anderen Duplexband erforderlich sind. D. h., ein HF-Filter benötigt in der Regel nur auf der Seite des Paßbandes eine steile Flanke, die dem anderen Duplexband zugewandt ist. Bei den augenblicklich gängigen Mobilfunksystemen auf der Basis von GSM, CDMA, AMPS oder TDMA ist dies im Falle eines Empfangsfilters die linke Flanke, im Falle eines Sendefilters hingegen die rechte Flanke.

Die Erfindung macht sich dies zunutze und gibt ein Reaktanzfilter an, das aus Resonatoren vom BAW-Typ aufgebaut ist. Es umfaßt zumindest ein Grundglied mit einem ersten Resonator in einem ersten Zweig und einem zweiten Resonator in einem zweiten Zweig, die parallel zueinander geschalten sind, wobei einer der Zweige der serielle Zweig, der andere Zweig dagegen ein paralleler Zweig ist. Jeder der Resonatoren weist ein spezifisches Verhältnis $V_c$ von dynamischer Kapazität C1 zu statischer Kapazität $C_0$ auf:

$$V_C = C1/C0,$$

wobei erfindungsgemäß das Verhältnis $V_c$ für den Resonator eines ersten Zweigs niedriger eingestellt ist als für den Resonator des zweiten Zweigs. In Abhängigkeit davon, in welchem Zweig das Verhältnis $V_c$ niedriger eingestellt wird, weist das erfindungsgemäße Reaktanzfilter ein Durchlaßverhalten mit einer verbesserten weil steileren Flanke auf. Die andere Flanke sowie die übrigen Resonator- und Filtereigenschaften bleiben davon unberührt. Wird beispielsweise bei einem Resonator im seriellen Zweig das Verhältnis $V_c$ gegenüber dem entsprechenden Verhältnis $V_c$ beim Resonator des parallelen Zweigs verringert, so wird die rechte Flanke des Paßbandes steiler eingestellt, also die Flanke, die das Paßband gegenüber höheren Frequenzen abgrenzt. Analog dazu wird bei einem Reaktanzfilter, bei dem der Resonator im parallelen Zweig ein kleineres Verhältnis $V_c$ aufweist als der Resonator im seriellen Zweig, ein Paßband mit einer steiler eingestellten linken Flanke erhalten. Da in einem Grundglied eines Reaktanzfilters die Resonanz- und Antiresonanzfrequenzen des parallelen Resonators niedriger liegen als die entsprechenden Frequenzen des seriellen Resonators, wird beispielsweise die rechte Flanke des Paßbandes durch die Eigenschaften des seriellen Resonators bestimmt. Die Steilheit der rechten Flanke ist daran zu ersehen, wie schnell die Impedanzkurve des seriellen Resonators von der Resonanzfrequenz zur Antiresonanzfrequenz hin ansteigt. Ein steilerer Impedanzanstieg in einem (seriellen) Resonator wird erhalten, wenn der Abstand zwischen Resonanz- und Antiresonanzfrequenz des Resonators verringert wird. Da umgekehrt die Steilheit der linken Flanke im wesentlichen von dem Parallelresonator bzw. dem Resonator im Parallelzweig bestimmt wird, gelingt eine steilere Einstellung der linken Flanke durch eine Verringerung des Abstandes von Resonanz- und Antiresonanzfrequenz des Parallelresonators.

Da ein reales Reaktanzfilter in der Regel durch Verschaltung mehrerer Grundglieder erhalten wird, weist ein Reaktanzfilter üblicherweise mehrere serielle Resonatoren und mehrere Parallelresonatoren auf. Ein erfindungsgemäßes Reaktanzfilter wird bereits dann erhalten, wenn die genannten Veränderungen in einem einzelnen Resonator eines Typs (seriell oder parallel) vorgenommen sind. Eine weiter verbesserte noch steilere Flanke wird erhalten, wenn mehrere Resonatoren eines Typs, vorzugsweise alle Resonatoren eines Typs einen geringeren Abstand von Resonanz- und Antiresonanzfrequenz aufweisen. Durch die gegebene Abhängigkeit der entsprechenden Größen voneinander wächst dieser Abstand mit dem genannten Verhältnis $V_c$ der dynamischen zur statischen Kapazität. Ein Resonator mit einem solchen verringerten Abstand wird im folgenden als schmalbandiger Resonator bezeichnet. Ein Resonator mit entsprechend größerem Abstand von Resonanz- und Antiresonanzfrequenz wird als breitbandiger Resonator bezeichnet.

Die Breitbandigkeit des Filters, also die Breite des Paßbandes wird unabhängig von der Verwendung zumindest eines schmalbandigen Resonators für einen ersten Zweig dadurch erreicht, daß im zweiten Zweig breitbandige Resonatoren eingesetzt werden.

Mit einem erfindungsgemäßen Filter mit beispielsweise verbesserter steilerer rechter Flanke wird als Ergebnis eine höhere Selektion bei Frequenzen erreicht, die etwas höher als die oberste Frequenz des Paßbandes liegen. Dies ist z. B. bei einem Filter von Vorteil, der in den aktuellen GSM- oder CDMA-basierten Mobilfunksystemen für die Filter im Sendepfad eingesetzt wird, die eine hohe Unterdrückung des Empfangsbandes zur Verfügung stellen müssen.

Umgekehrt wird ein erfindungsgemäßes Filter mit beispielsweise verbesserter steilerer linker Flanke durch schmalbandige Parallelresonatoren erreicht, die im Ergebnis eine hohe Selektion bei Frequenzen erreichen, die etwas tiefer als die unterste Frequenz des Paßbandes des Filters liegen. Solche Filter werden vorzugsweise als Filter im Empfangspfad der aktuellen GSM- oder CDMA-basierten Mobilfunksysteme eingesetzt, die eine hohe Unterdrückung des Sendebands zur Verfügung stellen müssen.

Über die bekannte formelmäßige Verknüpfung des effektiven Kopplungskoeffizienten $K^2_{eff}$ mit der Lage von Resonanz- und Antiresonanzfrequenz:

$$K^2_{eff} = (\pi/2)^2 \ \text{x} \ \frac{fa - fr}{fa} \qquad\qquad (1.5)$$

ergibt sich, daß ein schmalbandiger Resonator auch durch direkte Beeinflussung des effektiven Kopplungskoeffizienten $K^2_{eff}$ erzielt werden kann. Ein schmalbandiger Resonator läßt sich auf einem geeigneten piezoelektrischen Material mit niedrigerem effektivem elektromechanischen Kopplungskoeffizienten realisieren. Dieser effektive elektromechanische Kopplungskoeffizient wiederum wird aus der Summe der effektiven Kopplungen aller in einem piezoelektrischen Material ausbreitungsfähigen Moden erhalten.

Da ein realer Filter in der Regel nur eine Mode nutzt, die Mittenfrequenzen der übrigen Moden dagegen ausreichend weit vom Paßband entfernt sind, läßt sich die effektive Kopplung (für die genutzte Mode) aus dem Ersatzschaltbild eines BAW-Resonators nach der folgenden Formel bestimmen:

$$k^2_{eff} \approx \frac{C1}{C_1 + C_0} \qquad\qquad (1.6)$$

Aus dieser Formel ergibt sich die Abhängigkeit der Schmalbandigkeit eines Resonators vom Verhältnis dynamischer zu statischer Kapazität eines Resonators, bzw. genaugenommen vom Verhältnis dynamischer zu statischer Kapazität der betrachteten bzw. genutzten Schwingungsmode des Resonators. Aus dieser Betrachtung ergibt sich, daß ein BAW-Resonator mit einem kleineren Verhältnis $V_c$ eine geringere effektive Kopplung $k^2_{eff}$ besitzt. Wird für den Aufbau eines Resonators ein Piezomaterial mit kleinem Kopplungskoeffizienten und damit kleiner effektiver Kopplung verwendet, so erhält man einen Resonator mit geringem Abstand von Resonanzfrequenz und Antiresonanzfrequenz. Bei Verwendung eines höherkoppelnden Piezomaterials erhält man einen Resonator mit höherem Abstand von Resonanzfrequenz und Antiresonanzfrequenz.

Ein erfindungsgemäßes Reaktanzfilter weist daher beispielsweise Resonatoren mit einem höherkoppelnden Piezomaterial im Serienzweig des Reaktanzfilters, Resonatoren mit niedrigerkoppelndem Piezomaterial hingegen im Parallelzweig desselben Filters auf. Ein solcher Filter weist dann eine hohe Steilheit der linken Flanke auf. Gleichzeitig behält das erfindungsgemäße Reaktanzfilter eine hohe Bandbreite, die durch den relativ hohen Abstand von Resonanzfrequenzen und Antiresonanzfrequenz in den Serienresonatoren gewährleistet wird.

Die effektive Kopplung kann in einem Reaktanzfilter mit BAW-Resonatoren außerdem dadurch reduziert werden, daß zwischen den beiden Elektroden eines BAW Resonators eine zusätzliche Schicht aus einem nicht-piezoelektrischen Material eingefügt wird. Der Kopplungskoeffizient verringert sich dabei um den Anteil, den die Schicht des nicht-piezoelektrischen Materials am Verhältnis der Schichtdicke des nicht-piezoelektrischen Materials zur gesamten Schichtdicke des Resonators hat. In jedem Fall wird mit einer solchen Schicht eine Verringerung der effektiven Kopplung erhalten, die für das Filter bzw. den Resonator gleichbedeutend mit einer Verringerung des Verhältnisses $V_c$ und damit auch gleichbedeutend mit einer Verringerung des Abstandes von Resonanz- und Antiresonanzfrequenz ist.

Eine weitere Möglichkeit, auf die effektive Kopplung einzuwirken, besteht in der Auswahl geeigneter Elektrodenmaterialien für die BAW-Resonatoren. Eine hohe elektromechanische Kopplung wird mit einem Elektrodenmaterial erzielt, das für die verwendete Mode eine hohe mechanische Impedanz der Elektrode bewirkt. Ein Elektrodenmaterial, das die effektive Kopplung (für die betrachtete bzw. genutzte Mode im Resonator) erhöht wird in Abhängigkeit von dessen Stellung des Elektrodenmetalls im Periodensystem der Elemente erhalten oder wird als empirischer Wert ermittelt. Ein erfindungsgemäßes Reaktanzfilter weist daher beispielsweise Resonatoren auf, die in einem ersten Zweig ein Elektrodenmaterial verwenden, welches sich von dem Elektrodenmaterial der Resonatoren im zweiten Zweig unterscheidet. Beispielsweise wird durch den Einsatz eines schweren Elektrodenmaterials wie beispielsweise Wolfram die effektive Kopplung erhöht, wobei ein im Vergleich zu einem Resonator mit Aluminium-Elektroden breitbandigerer Resonator erhalten wird. Ein Reaktanzfilter mit Resonatoren mit Wolfram-Elektroden in einem ersten Zweig und Resonatoren mit Aluminium-Elektroden in einem zweiten Zweig hat demgemäß einen schmalbandigeren Resonator im zweiten Zweig. Ist der zweite Zweig ein paralleler Zweig, wird die linke Flanke des Paßbandes des Reaktanzfilters verbessert. Wird der entsprechend schmalbandige Resonator im seriellen Zweig eingesetzt, wird im Reaktanzfilter die rechte Flanke verbessert.

Ein BAW-Resonator ist vorzugsweise beiderseits der Elektroden von Luft umgeben. In der technischen Realisierung werden dazu zwei weit voneinander entfernte Auflagepunkte für eine Elektrodenschicht vorgesehen, wobei man von sogenannten Bridge-Resonatoren spricht. In diesen Bridge-Resonatoren wird die akustische Welle auf beiden Seiten des Resonators am Übergang Festkörper/Luft reflektiert. Möglich ist es jedoch auch, einen BAW-Resonator so auszubilden, daß eine der Elektroden ganzflächig auf einem Substrat aufliegt. Die Reflexion der akustischen Welle kann dann mit einem akustischen Spiegel gewährleistet werden, welcher beispielsweise durch zwei Schichten unterschiedlicher akkustischer Impedanz realisiert werden kann, die jeweils eine Schichtdicke von $\lambda/4$ bezogen auf die Wellenlänge $\lambda$ der akustischen Welle innerhalb des Schichtmaterials aufweisen. Die wiederholten Reflexionen an den Übergängen zweier Schichten mit stark unterschiedlichen akustischen Impedanzen führen dann zur Auslöschung der an unterschiedlichen Grenzflächen reflektierten Wellenanteile, was für den Spiegel wiederum eine hohe Reflexion bedeutet.

Bei Verwendung eines Resonators mit einem akustischen Spiegel befindet sich jedoch ein Teil der mechanischen Energie des Resonators außerhalb der Elektroden. Innerhalb der Schichtfolge Elektrode/Piezomaterial/Elektrode ändert sich daher das Verhältnis der elektrischen zur mechanischen Energie und damit die effektive Kopplung, die sich nach folgender Formel bemißt:

$$k^2{}_{\mathrm{eff}} = \frac{u_E}{u_E + u_M}, \qquad\qquad (1.7)$$

wobei $u_E$ die elektrische Energiedichte und $u_M$ die mechanische Energiedichte bedeuten. Aus der Formel geht klar hervor, daß sich die effektive Kopplung eines Resonators mit akustischem Spiegel um den Betrag $u_M$ gegenüber einem Bridge-Resonator reduziert. Dies bedeutet, daß Resonatoren mit einem akustischen Spiegel eine geringere effektive Kopplung und damit einen geringeren Abstand von Resonanz- und Antiresonanzfrequenz als Bridgeresonatoren haben. Ein erfindungsgemäßes Reaktanzfilter weist daher beispielsweise im Parallelzweig Bridgeresonatoren, im seriellen Zweig dagegen Resonatoren mit akustischem Spiegel auf, wobei ein Durchlaßverhalten mit einem in der rechten Flanke steilerem Paßband erhalten wird.

Möglich ist es auch, die effektive Kopplung $k^2{}_{\mathrm{eff}}$ eines Resonators durch Verwendung unterschiedlicher akustischer Spiegel zu beeinflussen. Dies kann durch unterschiedlich dicke Spiegelschichten oder durch Spiegelschichten mit unterschiedlichem Material erfolgen. Ein erfindungsgemäßes Reaktanzfilter zeichnet sich dann durch Resonatoren aus, die in einem ersten Zweig zumindest zum Teil andere akustische Spiegel verwenden als in einem zweiten Zweig.

Im folgenden wird die Erfindung anhand von Ausführungsbeispielen und den dazugehörigen Figuren näher erläutert.

Figur 1a bis 1c zeigen einen BAW-Resonator im schematischen Querschnitt, dessen Ersatzschaltbild sowie das ersatzweise verwendete Symbol für einen Resonator.

Figuren 2 und 3 zeigen zwei Möglichkeiten zur Verschaltung zweier Grundglieder zu einem Filter.

Figur 4 zeigt ein Reaktanzfilter mit drei Grundgliedern.

Figur 5 zeigt ein Reaktanzfilter mit vier Grundgliedern.

Figur 6 zeigt die Dämpfungskurven für ein breitbandiges und ein schmalbandiges Filter.

Figur 7 zeigt ein Grundglied eines Reaktanzfilters, aufgebaut aus BAW-Resonatoren.

Figur 8 zeigt eine vereinfachte Filterstruktur mit drei Grundgliedern.

Figur 9 zeigt das gleiche Filter mit vereinfachter Struktur.

Figuren 10 und 11 zeigen das Durchlassverhalten erfindungsgemäßer Reaktanzfilter.

Figur 12 zeigt die Impedanzkurven von Resonatoren mit unterschiedlichen Elektrodenmaterialien.

Figur 13 zeigt einen Resonator mit zusätzlicher dielektrischer Schicht.

Figur 14 zeigt einen Bridge-Resonator im schematischen Querschnitt.

Figur 15 zeigt einen BAW-Resonator mit akustischem Spiegel.

Figuren 16a und 16b zeigen übereinandergelegte Admittanz- und Impedanzkurven für Einzelresonatoren bzw. das Dämpfungsverhalten eines Reaktanzfilters.

Erstes Ausführungsbeispiel:

Es werden entsprechend Figur 1 aufgebaute Resonatoren zu einem Reaktanzfilter verschaltet. Jeder Resonator umfaßt eine erste Elektrodenschicht E1, eine piezoelektrische Schicht P und eine zweite Elektrodenschicht E2. Im rechten Teil der Figur ist das üblicherweise für Resonatoren verwendete Symbol aufgezeigt.

Figur 7 zeigt ein Grundglied, welches aus einem ersten Resonator R1 in einem Parallelzweig und einem zweiten Resonator R2 in einem seriellen Zweig aufgebaut ist. Die Anschlüsse 3-1 und 3-2 bilden den Eingang des Filters, die Anschlüsse 3-3 und 3-4 den Ausgang des Filters. Der Parallelzweig bzw. der Resonator R1 im Parallelzweig ist über

eine Serieninduktivität $L_{ser}$, gebildet aus der Summe der Induktivitäten des Anschlußes an die Gehäusemasse, mit den Anschlüssen 3-2 bzw. 3-4 verbunden. Erfindungsgemäß wird in diesem Ausführungsbeispiel der Resonator R1 mit einer piezoelektrischen Schicht aus Zinkoxid mit einer elektromechanischen Kupplungskonstante $K^2_{eff}$ 1 und der Resonator R2 mit einer piezoelektrischen Schicht p aus Aluminiumnitrid mit einer piezoelektrischen Kopplungskonstante $K^2_{eff}$ 2 ausgebildet, wobei $K^2_{eff}$ 1 > $K^2_{eff}$ 2. Über die jeweilige Dicke der piezoelektrischen Schicht bzw. die Dicke des gesamten Resonators werden die Resonanzfrequenzen und damit auch die Antiresonanzfrequenzen der beiden Resonatoren R1 und R2 so eingestellt, daß die Resonanzfrequenz von R2 ungefähr gleich bei der Antiresonanzfrequenz von R1 liegt.

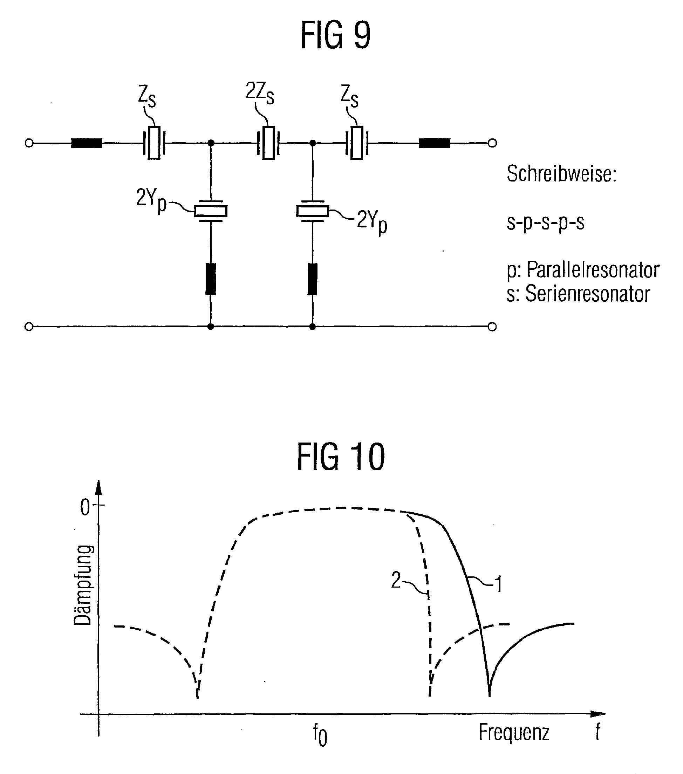

Die Durchlaßkurve 2 in Figur 10 zeigt das Dämpfungsverhalten eines erfindungsgemäßen Reaktanzfilters gemäß diesem Ausführungsbeispiel, die der Durchlaßkurve 1 eines herkömmlichen Reaktanzfilters gegenüber gestellt ist, bei dem beide Resonatoren Zinkoxid für die piezoelektrische Schicht p der Resonatoren verwenden. Es zeigt sich, daß die rechte Flanke der Kurve 2 deutlich steiler eingestellt ist als die des bekannten Filters. Die Bandbreite des Gesamtfilters ist nur unwesentlich reduziert.

Zweites Ausführungsbeispiel:

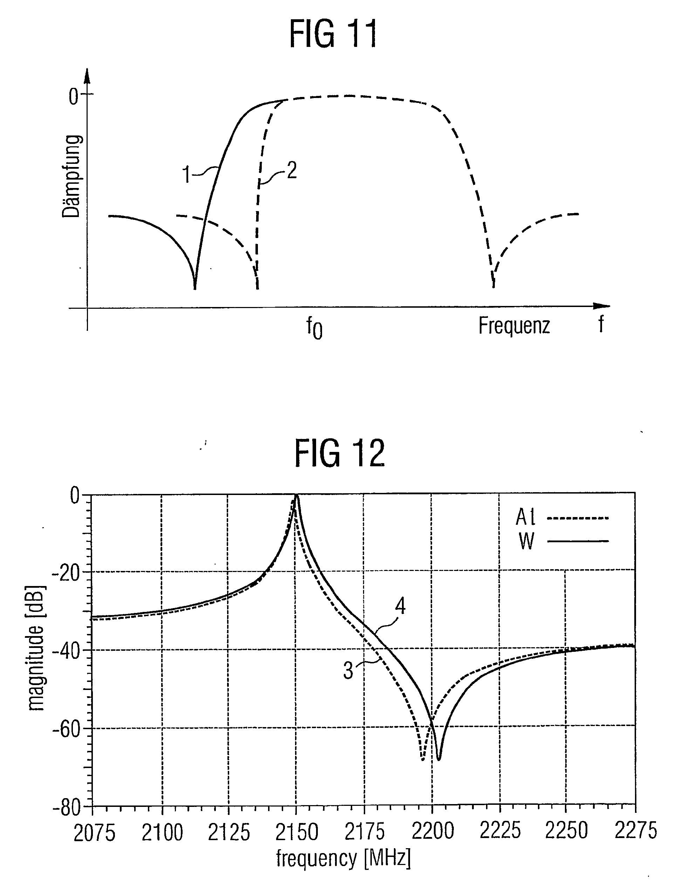

Es wird wiederum ein Reaktanzfilter mit einem gemäß Figur 2 verschalteten Grundglied aufgebaut, wobei beide Resonatoren wie in Figur 1 ausgebildet sind. Im Unterschied zum ersten Ausführungsbeispiel weisen beide Resonatoren zwar das gleiche piezoelektrische Material für die Schicht p auf, unterscheiden sich jedoch im verwendeten Elektrodenmaterial für die Elektroden E1 und E2. Während für die Resonatoren R1 Aluminium verwendet wird, dient als Elektrodenmaterial für die Resonatoren R2 Wolfram. Da für die effektive Kopplung $k^2_{eff}$ gilt $k^2_{eff}$ 2 > $k^2_{eff}$ 1, wird im Ergebnis ein Reaktanzfilter erhalten, dessen Durchlaßkurve 2 in Figur 11 dargestellt ist. Es zeigt sich, daß die Kurve 2 des erfindungsgemäßen Filters eine linke Flanke aufweist, die deutlich steiler eingestellt ist als die linke Flanke der Kurve 1, die das Durchlaßverhalten eines bekannten Reaktanzfilters zeigt, bei dem für beide Resonatoren das gleiche Elektrodenmaterial (Wolfram) verwendet wurde.

Figur 12 zeigt den Einfluß des Elektrodenmaterials auf das Impedanzverhalten eines Resonators. Die Kurven 3 und 4 zeigen das Impedanzverhalten gemäß Figur 1 ausgebildeter Resonatoren, wobei Kurve 3 die Impedanz eines Resonators mit Aluminiumelektroden, die Kurve 4 dagegen das Impedanzverhalten eines Resonators mit Wolframelektroden darstellt. Es zeigt sich, daß die größere effektive Kopplung von Wolframelektroden gemäß der Kurve 4 zu einem höheren Abstand der Resonanzfrequenz von der Antiresonanzfrequenz führt.

Drittes Ausführungsbeispiel:

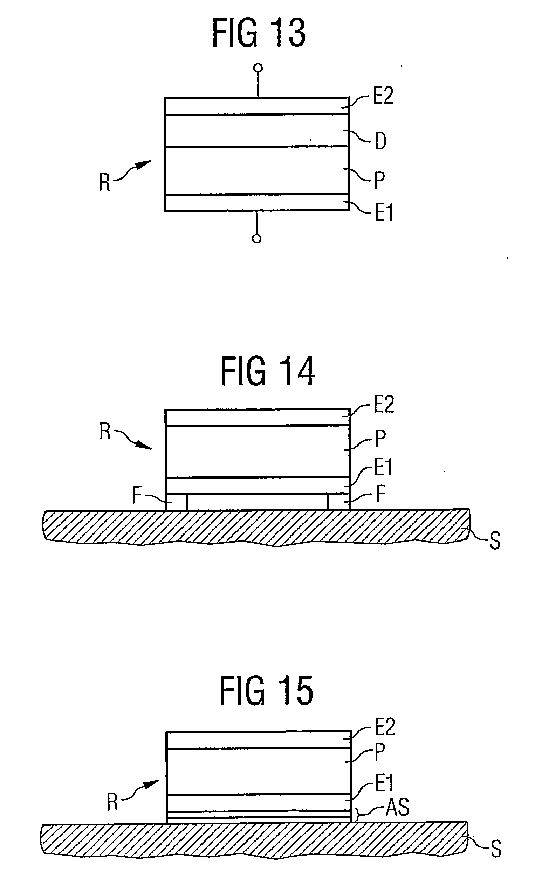

Es wird ein Resonator gemäß Figur 13 ausgebildet. Dieser umfaßt zwischen einer ersten Elektrode E1 und einer zweiten Elektrode E2, beispielsweise aus Aluminium, eine piezoelektrische Schicht P, beispielsweise aus Aluminiumnitrid sowie eine dielektrische Schicht D beispielsweise aus Siliziumoxid. Bei einem Schichtanteil der Siliziumdioxidschicht von 16% sinkt der Kopplungskoeffizient $k^2_{eff}$ von einem Wert von 0,0645, bestimmt an einem Resonator gemäß Figur 1 mit Aluminiumnitrid als piezoelektrische Schicht auf einen Wert von 0,057 für den erfindungsgemäß wie in Figur 13 ausgebildeten Resonator. Dieser weist daher einen geringeren Abstand von Resonanz- und Antiresonanzfrequenz auf und läßt sich in Kombination mit herkömmlichen Resonatoren (siehe Figur 1) kombinieren, wobei im Reaktanzfilter (beispielsweise gemäß Figur 7) die seriellen und parallelen Resonatoren unterschiedlich ausgebildet sind, nämlich jeweils gemäß Figur 1 bzw. Figur 17.

Viertes Ausführungsbeispiel:

Figur 14 zeigt einen als Bridge-Resonator ausgebildeten BAW-Resonator. Dieser weist einen Figur 1 entsprechenden Grundkörper auf, ist jedoch zusätzlich über zwei Sockelstrukturen F mit einem Substrat S verbunden. Da der überwiegende Teil der unteren Elektrode E1 des Resonators Luft als Grenzfläche aufweist, verhält sich dieser Bridgeresonator annähernd wie ein Resonator, der völlig frei schwingen kann. An den beiden Grenzflächen E1/Luft bzw. E2/Luft erfolgt dabei Totalreflektion der akustischen Welle.

Figur 15 zeigt einen Resonator, der mit Hilfe eines akustischen Spiegels AS auf einem Substrat S angeordnet ist.

Ein erfindungsgemäßes Reaktanzfilter wird nun aus zumindest einem Grundglied (beispielsweise gemäß Figur 7) hergestellt, wobei in einem ersten Zweig Resonatoren in Bridgebauweise, in einem zweiten Zweig dagegen Resonatoren mit akustischem Spiegel eingesetzt werden. Da der effektive Kopplungskoeffizient für Resonatoren gemäß Figur 14 größer ist als bei Resonatoren gemäß Figur 15, läßt sich diejenige Flanke des Paßbandes steiler gestalten, die dem Zweig mit den Resonatoren mit akustischem Spiegel zugeordnet ist. Werden beispielsweise die Resonatoren R1 mit akustischem Spiegel ausgeführt, die Resonatoren R2 als Bridgeresonatoren, wird eine steilere linke Flanke im Durchlaßverhalten des so konstruierten Reaktanzfilters erhalten.

Obwohl die Erfindung nur anhand einiger Ausführungsbeispiele dargestellt und erläutert werden konnte, ist sie selbstverständlich nicht auf diese beschränkt. Mögliche Ausgestaltungen der Erfindung betreffen weitere Methoden, die Bandbreite eines einzelnen Resonators zu variieren und dementsprechend Resonatoren mit unterschiedlichen Bandbreiten in erfindungsgemäßen Filtern einzusetzen. Die Variationen können dabei einzelne Resonatoren in einem Zweig, einzelne Resonatoren in beiden Zweigen, alle Resonatoren in einem Zweig oder alle Resonatoren in beiden Zweigen umfassen.

**Patentansprüche**

1.  Reaktanzfilter, aufgebaut aus Resonatoren vom BAW Typ,

    - umfassend zumindest ein Grundglied mit einem ersten Resonator in einem ersten Zweig und einem zweiten Resonator in einem zweiten Zweig, wobei einer der Zweige ein serieller Zweig und der andere Zweig ein paralleler Zweig ist,
    - bei dem jeder Resonator ein spezifisches Verhältnis $V_c = C1/C_0$ von dynamischer zu statischer Kapazität aufweist,
    - **dadurch gekennzeichnet, daß** das Verhältnis $V_c$ für den Resonator des zweiten Zweigs kleiner eingestellt ist als für den Resonator des ersten Zweigs.

2.  Reaktanzfilter nach Anspruch 1,

    - bei dem der Resonator des ersten Zweigs aus einem ersten piezoelektrischen Material und der Resonator des zweiten Zweigs aus einem davon unterschiedlichen zweiten piezoelektrischen Material besteht, und
    - bei dem der Kopplungskoeffizient des ersten Materials höher ist als der des zweiten piezoelektrischen Materials.

3.  Reaktanzfilter nach Anspruch 1 oder 2,
    bei dem die Elektrodenmaterialien für die Resonatoren des ersten und zweiten Zweigs unterschiedlich sind, wobei das Elektrodenmaterial für die Resonatoren des ersten Zweigs eine höhere effektive Kopplung erzeugt als das Elektrodenmaterial der Resonatoren des zweiten Zweigs.

4.  Reaktanzfilter nach einem der Ansprüche 1 bis 3,
    bei dem die Resonatoren des zweiten Zweigs BAW Resonatoren umfassen, bei denen zwischen zwei Elektroden neben einer Schicht eines piezoelektrischen Materials noch eine Schicht eines weiteren Materials vorgesehen ist, das eine niedrigere dielektrische Konstante als das piezoelektrische Material aufweist.

5.  Reaktanzfilter nach einem der Ansprüche 1 bis 4,
    bei dem der effektive Kopplungskoeffizient für die Resonatoren des zweiten Zweigs durch Verwendung eines akustischen Spiegels unterhalb einer Elektrodenschicht gegenüber dem Kopplungskoeffizient der Resonatoren des ersten Zweigs erniedrigt ist.

6.  Reaktanzfilter nach Anspruch 5,
    bei dem die Resonatoren vom ersten und zweiten Zweig akustische Spiegel aufweisen, die bezüglich der Schichtdicken der Spiegelschichten und/oder Reflexionseigenschaften in den beiden Zweigen unterschiedlich sind.

7.  Reaktanzfilter nach Anspruch 5,
    bei dem nur die Resonatoren des zweiten Zweigs einen akustischen Spiegel aufweisen und bei den Resonatoren des ersten Zweigs eine andere Methode der Reflexion akustischer Wellen verwendet wird.

8.  Reaktanzfilter nach einem der Ansprüche 1 bis 7, umfassend mehrere miteinander verschaltete Grundglieder, wobei die seriellen Zweige der Grundglieder in Serie zueinander geschaltet sind, die Parallelzweige hingegen dazu parallel.

9.  Reaktanzfilter nach Anspruch 8,
    bei dem das Verhältnis $V_c = C1/C_0$ von dynamischer zu statischer Kapazität in mindestens einem Resonator des seriellen Zweigs auf einen anderen Wert eingestellt ist als das entsprechende Verhältnis der Resonatoren in den Parallelzweigen.

10. Reaktanzfilter nach einem der Ansprüche 1 bis 9,
    aufweisend ein Durchlaßverhalten mit einem Passband mit steilerer linker Flanke, bei dem das Verhältnis $V_c =$

$C1/C_0$ von dynamischer zu statischer Kapazität in mindestens einem Resonator der parallelen Zweige gegenüber den Resonatoren des seriellen Zweigs erniedrigt ist.

11. Reaktanzfilter nach einem der Ansprüche 1 bis 9,
aufweisend ein Durchlaßverhalten mit einem Passband mit steilerer rechter Flanke, bei dem das Verhältnis $V_c = C1/C_0$ von dynamischer zu statischer Kapazität in mindestens einem Resonator des seriellen Zweigs gegenüber den Resonatoren der parallelen Zweige erniedrigt ist.

12. Reaktanzfilter nach einem der Ansprüche 1 bis 11,
bei dem die Resonatoren der Parallelzweige in Serie mit einer Induktivität geschaltet und jeweils einzeln mit einem Masseanschluß verbunden sind.

13. Verwendung eines Reaktanzfilters nach einem der vorangehenden Ansprüche in einem drahtlosen Kommunikationssystem mit Sende- und Empfangsteil, wobei für das Filter des Sendeteils ein Reaktanzfilter mit steilerer rechter Flanke und für das Filter des Empfangsteils ein Reaktanzfilter mit steilerer linker Flanke eingesetzt wird.

14. Verwendung eines Reaktanzfilters nach einem der vorangehenden Ansprüche in einem Duplexer mit zwei Paßbandfiltern, wobei für das Filter mit der niedrigeren Mittenfrequenz ein Reaktanzfilter mit steilerer rechter Flanke und für das Filter mit der höheren Mittenfrequenz ein Reaktanzfilter mit steilerer linker Flanke eingesetzt wird.

**Claims**

1. Reactance filter, formed from resonators of the BAW type,

    - having at least one basic element with a first resonator in a first branch and a second resonator in a second branch, wherein one of the branches is a serial branch and the other branch is a parallel branch,
    - wherein each resonator has a specific ratio $V_c = C1/C_0$ of dynamic to static capacitance,
    - **characterized in that** the ratio $V_c$ for the resonator in the second branch is set to lower than for the resonator in the first branch.

2. Reactance filter according to Claim 1,

    - wherein the resonator in the first branch is composed of a first piezoelectric material, and the resonator in the second branch is composed of a second piezoelectric material, which is not the same as the first, and
    - wherein the coupling coefficient of the first material is higher than that of the second piezoelectric material.

3. Reactance filter according to Claim 1 or 2,
wherein the electrode materials for the resonators in the first and second branches are different, wherein the electrode material for the resonators in the first branch produces higher effective coupling than the electrode material of the resonators in the second branch.

4. Reactance filter according to one of Claims 1 to 3,
wherein the resonators in the second branch have BAW resonators, wherein a layer of a further material is also provided, in addition to a layer of a piezoelectric material, between two electrodes, which further material has a lower dielectric constant than the piezoelectric material.

5. Reactance filter according to one of Claims 1 to 4,
wherein the effective coupling coefficient for the resonators in the second branch is reduced in comparison to the coupling coefficient of the resonators in the first branch by using an acoustic mirror under an electrode layer.

6. Reactance filter according to Claim 5,
wherein the resonators in the first and second branches have acoustic mirrors which have different layer thicknesses of the mirror layers and/or different reflection characteristics in the two branches.

7. Reactance filter according to Claim 5,
wherein only the resonators in the second branch have an acoustic mirror, and a different method for reflection of acoustic waves is used for the resonators in the first branch.

8. Reactance filter according to one of Claims 1 to 7,
having a plurality of basic elements which are interleaved with one another, wherein the serial branches of the basic elements are connected in series with one another, while the parallel branches are in contrast connected in parallel.

9. Reactance filter according to Claim 8,
wherein the ratio $V_c$ = C1/C$_0$ of dynamic to static capacitance in at least one resonator in the serial branch is set to a different value than the corresponding ratio of the resonators in the parallel branches.

10. Reactance filter according to one of Claims 1 to 9,
having a pass response with a passband with a steep left-hand skirt, wherein the ratio $V_c$ = C1/C$_0$ of dynamic to static capacitance in at least one resonator in the parallel branches is reduced in comparison to the resonators in the serial branch.

11. Reactance filter according to one of Claims 1 to 9,
having a pass response with a passband with a steep right-hand skirt, wherein the ratio $V_c$ = C1/C$_0$ of dynamic to static capacitance in at least one resonator in the serial branch is reduced in comparison to the resonators in the parallel branches.

12. Reactance filter according to one of Claims 1 to 11,
wherein the resonators in the parallel branches are connected in series with an inductance, and are each individually connected to an earth connection.

13. Use of a reactance filter according to one of the preceding claims in a wire-less communication system with a transmitting and receiving part, wherein a reactance filter with a steep right-hand skirt is used for the filter in the transmitting part, and a reactance filter with a steep left-hand skirt is used for the filter in the receiving part.

14. Use of a reactance filter according to one of the preceding claims in a duplexer with two passband filters, wherein a reactance filter with a steep right-hand skirt is used for the filter with the lower mid-frequency, and a reactance filter with a steep left-hand skirt is used for the filter with the higher mid-frequency.

**Revendications**

1. Filtre à réactance constitué de résonateurs du type BAW,

   - comprenant au moins un élément de base ayant un premier résonateur dans une première branche et un deuxième résonateur dans une deuxième branche, l'une des branches étant une branche série et l'autre branche une branche parallèle,
   - dans lequel chaque résonateur a un rapport $V_C$ = C1/C$_O$ de la capacité dynamique à la capacité statique,

   **caractérisé en ce que** le rapport $V_C$ du résonateur de la deuxième branche est réglée d'une manière à être plus petite que celui du résonateur de la première branche.

2. Filtre à réactance suivant la revendication 1,

   - dans lequel le résonateur de la première branche est en un premier matériau piézo-électrique et le résonateur de la deuxième branche est en en un deuxième matériau piézo-électrique qui en diffère, et
   - dans lequel le coefficient de couplage du premier matériau est plus grand que celui du deuxième matériau piézo-électrique.

3. Filtre à réactance suivant la revendication 1 ou 2,
dans lequel les matériaux d'électrode des résonateurs de la première et de la deuxième branches sont différents, le matériau d'électrode des résonateurs de la première branche produisant un couplage efficace plus grand que le matériau d'électrode des résonateurs de la deuxième branche.

4. Filtre à réactance suivant l'une des revendications 1 à 3,
dans lequel les résonateurs de la deuxième branche comprennent des résonateurs BAW dans lesquels il est prévu entre deux électrodes, outre une couche d'un matériau piézo-électrique, encore une couche d'un autre matériau qui a une constante diélectrique plus petite que le matériau piézo-électrique.

**5.** Filtre à réactance suivant l'une des revendications 1 à 4,
dans lequel le coefficient de couplage efficace des résonateurs de la deuxième branche est abaissé en utilisant un miroir acoustique en dessous d'une couche d'électrode par rapport au coefficient de couplage des résonateurs de la première branche.

**6.** Filtre à réactance suivant la revendication 5,
dans lequel les résonateurs de la première et de la deuxième branches ont des miroirs acoustiques qui, en ce qui concerne les épaisseurs des couches de miroir et/ou les propriétés de réflexion, sont différents dans les deux branches.

**7.** Filtre à réactance suivant la revendication 5,
dans lequel seuls les résonateurs de la deuxième branche ont un miroir acoustique et dans lequel des résonateurs de la première branche utilisent un autre procédé de réflexion des ondes acoustiques.

**8.** Filtre à réactance suivant l'une des revendications 1 à 7,
comprenant plusieurs éléments de base câblés entre eux, les branches en série des éléments de base étant montées en série les une avec les autres, tandis que les branches en parallèle le sont en parallèle.

**9.** Filtre à réactance suivant la revendication 8,
dans lequel le rapport $V_C = C1/C_O$ de la capacité dynamique à la capacité statique d'au moins un résonateur de la branche série est ajusté à une valeur autre que le rapport correspondant des résonateurs dans les branches parallèles.

**10.** Filtre à réactance suivant l'une des revendications 1 à 9,
ayant un comportement à la transmission ayant une bande passante ayant un front gauche plus abrupt, dans lequel le rapport $V_C = C1/C_O$ de la capacité dynamique à la capacité statique est abaissé dans au moins un résonateur des branches parallèles par rapport aux résonateurs de la branche série.

**11.** Filtre à réactance suivant l'une des revendications 1 à 9,
ayant un comportement à la transmission ayant une bande passante ayant un front droit plus abrupt, dans lequel le rapport $V_C = C1/C_O$ de la capacité dynamique à la capacité statique est abaissé dans au moins un résonateur de la branche série par rapport aux résonateurs des branches parallèles.

**12.** Filtre à réactance suivant l'une des revendications 1 à 11,
dans lequel les résonateurs des branches parallèles sont montés en série avec une inductance et sont reliés respectivement individuellement à une borne de masse.

**13.** Utilisation d'un filtre à réactance suivant l'une des revendications précédentes, dans un système de communication sans fil ayant une section d'émission et une section de réception, dans laquelle on met en oeuvre pour le filtre de la partie d'émission un filtre à réactance ayant un front droit plus abrupt et pour le filtre de la partie de réception un filtre à réactance ayant un front gauche plus abrupt.

**14.** Utilisation d'un filtre à réactance suivant l'une des revendications précédentes, dans un duplexeur ayant deux filtres bande passante, dans laquelle on met en oeuvre, pour le filtre ayant la fréquence médiane la plus basse, un filtre à réactance ayant un front droit plus abrupt et pour le filtre ayant la fréquence médiane la plus haute un filtre à réactance ayant un front gauche plus abrupt.

## FIG 1a

## FIG 1b

## FIG 1c

## FIG 2

# FIG 3

# FIG 4

Schreibweise:

p-s-s-p-p-s

p: Parallelresonator
s: Serienresonator

# FIG 5

$Z_S$     $Z_S$   $Z_S$     $Z_S$

$Y_p$     $Y_p$     $Y_p$     $Y_p$

Schreibweise:

s-p-p-s-s-p-p-s

p: Parallelresonator
s: Serienresonator

# FIG 6

Dämpfung

0

2 1

$f_0$    Frequenz    f

## FIG 7

## FIG 8

Schreibweise:

p-s-p-s

p: Parallelresonator
s: Serienresonator

## FIG 9

Schreibweise:

s-p-s-p-s

p: Parallelresonator
s: Serienresonator

## FIG 10

# FIG 11

# FIG 12

## FIG 13

E2
D
P
E1
R

## FIG 14

R
E2
P
E1
F
F
S

## FIG 15

E2
P
E1
AS
R
S

## FIG 16a

## FIG 16b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19638451 A

- JP 63253711 A

**In der Beschreibung aufgeführte Nicht-Patentliteratur**

- **von K. M. Lakin et al.** Microwave Symposium Digest. *IEEE MTT-S international,* 1995, 883-886